# EUROPÄISCHE PATENTANMELDUNG

(11) **EP 4 682 568 A1**
(43) Veröffentlichungstag der Anmeldung: **21.01.2026**
(21) Anmeldenummer: 25187859.1
(22) Anmeldetag: 07.07.2025
(51) Int. Cl.: G01R 31/58, G01R 31/69

(54) **PRÜFTISCH-SYSTEM ZUR PRÜFUNG VON KABELBÄUMEN**

(30) Priorität: 19.07.2024 DE 102024206794
(71) Anmelder: LEONI Bordnetz-Systeme GmbH, 97318 Kitzingen (DE); LEONI Wiring Systems Slovakia spol. s r.o., 911 01 Trencin (SK); Leoni Wiring Systems UK Limited, Newcastle-under-Lyme, Staffordshire ST5 9BT (GB)
(72) Erfinder: EGBERS, Andreas, 97340 Marktbreit (DE); KALIANKO, Imrich, 91101 Trencín (SK); MATAVA, Lubomir, 911 01 Trencin (SK); RAHMAN, Mehbub-Ur, 97318 Kitzingen (DE); WEBB, Robert, Stoke-On-Trent, ST6 8HL (GB); YEOLE, Aniket, 97318 Kitzingen (DE)
(74) Vertreter: FDST Patentanwälte

(57) **Zusammenfassung**

Das Prüftisch-System (2) dient zur Prüfung von Kabelbäumen und ist für eine einfache Anpassung an unterschiedliche Kabelbäume modular ausgebildet und kann in unterschiedlichen Prüftisch-Konfigurationen aufgebaut werden und weist hierzu ein Basisgestell (4) auf, welches eine zentrale Prüfeinheit (26) aufweist, wobei das Prüftisch-System (2) weiterhin
- mehrere unterschiedliche Typen von Prüfaufsätzen (8) aufweist, die zur Ausbildung der unterschiedlichen Prüftisch-Konfigurationen wahlweise auf das Basisgestell (4) aufgesetzt werden können und deren Prüfmodule (18A) jeweils mit der zentralen Prüfeinheit (26) im montierten Zustand verbunden sind, und / oder
- zumindest ein Erweiterungsgestell (6) aufweist, welches seitlich am Basisgestell (4) zur Ausbildung der unterschiedlichen Prüftisch-Konfigurationen montierbar ist, wobei auf dem zumindest einen Erweiterungsgestell (6) im montierten Zustand ein Prüfaufsatz (8) angebracht ist, dessen Prüfmodule (18A) im montierten Zustand mit der zentralen Prüfeinheit (26) verbunden sind

## Beschreibung

Die Erfindung betrifft ein Prüftisch-System zur Prüfung von Kabelbäumen.

Prüftische dienen allgemein zur Überprüfung der Funktionsfähigkeit von Kabelbäumen und werden speziell bei der Herstellung von Kabelbäumen für Kraftfahrzeuge regelmäßig eingesetzt. Bei den Kabelbäumen handelt es sich häufig um komplexe Gebilde aus einer Vielzahl von einzelnen elektrischen Leitungen, die zu einem Kabelbaum miteinander verbunden sind. Der Kabelbaum weist häufig eine verzweigte Struktur auf. Üblicherweise sind in Endbereichen eines jeweiligen Teilstrangs des Kabelbaums Stecker angeschlossen. Daneben können auch elektronische Einheiten, wie beispielsweise (dezentrale) Steuereinheiten, Sensoren oder Aktoren vorkonfiguriert Teil des Kabelbaums sein. Der Kabelbaum besteht beispielsweise auch lediglich aus einzelnen Leitungen, die zu einem Kabelstrang zusammengefasst sind. Ein solcher Kabel- oder Leitungsstrang ist beispielsweise auch unverzweigt.

Ein Prüftisch weist regelmäßig eine Vielzahl von Prüfmodulen auf, an denen beispielsweise die Stecker oder auch die sonstigen elektronischen Einheiten zu Prüfzwecken angeschlossen werden können. Speziell werden bei einer solchen Prüfung die verschiedenen Leitungen auf Durchgängigkeit geprüft, es wird also geprüft, ob die gewünschten Leitungsverbindungen zwischen zwei Anschlussstellen tatsächlich auch ausgebildet sind. Hierzu wird beispielsweise eine Widerstandsmessung durchgeführt.

Die einzelnen Prüfmodule sind hierbei mit einer Prüfeinheit verbunden, über die die Prüfmodule mit Energie versorgt oder mit Prüfsignalen beaufschlagt werden.

Die Prüfeinheit ist daher häufig als eine Messeinheit zur Abgabe von Prüfsignalen und auch zur Auswertung derselben ausgebildet. Alternativ können bereits auch sogenannte intelligente Prüfmodule eingesetzt werden, bei denen die Prüfsignale und/oder die Auswertung dezentral an einem jeweiligen Prüfmodul erfolgt. Derartige intelligente Prüfmodule stehen mit der Prüfeinheit zumindest in Kommunikationsverbindung.

Derartige Prüftische werden an einen jeweiligen zu prüfenden Kabelbaum angepasst. Üblicherweise können die einzelnen Prüfmodule hierzu an unterschiedlichen Positionen des Prüftisches angeordnet werden. Die Prüfmodule bilden üblicherweise zusammen mit Leermodulen insgesamt ein variabel gestaltbares Prüffeld aus, auf dem der Kabelbaum aufgelegt werden kann.

Unterscheiden sich die Kabelbäumen grundsätzlich beispielsweise im Hinblick auf ihre Geometrie und / oder Größe, so kommen häufig unterschiedliche Prüftische zum Einsatz. Diese werden beispielsweise jeweils für einen oder wenige Kabelbaum-Typen angefertigt. Aufgrund dieser Kabelbaum-spezifischen Ausgestaltung ist die Benutzung des jeweiligen Prüftisches für andere Typen von Kabelbäumen nicht oder nur teilweise möglich. Zumindest sind kostenintensive und zeitaufwändige Umbaumaßnahmen erforderlich.

Ausgehend hiervon liegt der Erfindung die Aufgabe zugrunde, ein Prüftisch-System zur Prüfung von Kabelbäumen anzugeben, welches sich in einfacher Weise auch an unterschiedliche Typen von Kabelbäumen anpassen lässt.

Die Aufgabe wird gemäß der Erfindung gelöst durch ein Prüftisch-System zur Prüfung von Kabelbäumen mit den Merkmalen des Anspruchs 1. Das Prüftisch-System weist ein Tischgestell mit zumindest einem darauf angebrachten Prüfaufsatz auf, welcher ein Prüffeld mit mehreren Prüfmodulen zum Anschluss von Kabelbaum-Elementen aufweist. Weiterhin ist eine zentrale Prüfeinheit angeordnet, welche mit den Prüfmodulen insbesondere drahtgebundenen oder alternativ auch drahtlos verbunden ist. Über die zentrale Prüfeinheit werden beispielsweise Prüfsignale an die Prüfmodule übermittelt. Alternativ oder ergänzend werden die Prüfmodule über die Prüfeinheit mit Energie versorgt, und/oder es ist eine Kommunikationsverbindung zwischen der Prüfeinheit und den Prüfmodulen ausgebildet. Die Prüfmodule können grundsätzlich auch als intelligente Prüfmodule ausgebildet sein.

Das Prüftisch-System ist weiterhin modular aufgebaut und lässt sich in unterschiedlichen Prüftisch-Konfigurationen aufbauen. Hierzu weist das Prüftisch-System ein Basisgestell auf, welches die zentrale Prüfeinheit aufweist.

Das Prüftisch-System umfasst weiterhin wahlweise oder in Kombination
- mehrere unterschiedliche Typen von Prüfaufsätzen, die zur Ausbildung der unterschiedlichen Prüftisch-Konfigurationen wahlweise auf das Basisgestell aufgesetzt werden können und deren Prüfmodule jeweils mit der zentralen Prüfeinheit im montierten Zustand verbunden sind, und / oder
- zumindest ein Erweiterungsgestell und vorzugsweise mehrere Erweiterungsgestelle, wobei das zumindest eine Erweiterungsgestell seitlich am Basisgestell zur Ausbildung der unterschiedlichen Prüftisch-Konfigurationen montierbar ist, wobei auf dem zumindest einen Erweiterungsgestell im montierten Zustand ein Prüfaufsatz angebracht ist, dessen Prüfmodule im montierten Zustand mit der zentralen Prüfeinheit verbunden sind

Durch diesen modularen Aufbau ist insgesamt ein aufwandsarmer und schneller Aufbau des Prüftisches in unterschiedliche Konfigurationen und damit eine Anpassung für unterschiedliche Typen von Kabelbäumen mit nur geringem Aufwand ermöglicht. Speziell lassen sich die einzelnen Prüftisch-Module in vielfältiger Weise für die unterschiedlichsten Kabelbäumen zu unterschiedlichen Prüftisch-Konfigurationen zusammensetzen.

Durch das Basisgestell mit der zentralen Prüfeinheit ist quasi ein Basismodul bereitgestellt, welches als Ausgangspunkt für die unterschiedlichsten Prüftisch-Konfigurationen herangezogen wird. Dieses Basismodul ist daher das Hauptteil des ausgebildeten Prüftisches, über das insbesondere sämtliche Versorgungseinheiten für den Prüftisch und speziell für die verschiedenen Prüfmodule bereitgestellt werden. Über dieses Basismodul erfolgt insbesondere bei Bedarf auch ein Anschluss an die Außenwelt außerhalb des Prüftisches, beispielsweise also an eine externe Energieversorgung oder auch an eine übergeordnete Steuereinheit. Das Basisgestell weist hierfür beispielsweise ein oder mehrere geeignete Außen-Schnittstellen auf.

Bevorzugt ist weiterhin im Basisgestell und beispielsweise in der zentralen Prüfeinheit eine Auswerteeinheit integriert, die zur Auswertung von Prüfsignalen und/oder zur Verarbeitung von Kommunikationssignalen herangezogen wird, die über die einzelnen, beispielsweise intelligenten Prüfmodule bereitgestellt werden.

Für die Verbindung der zentralen Prüfeinheit mit den Prüfmodulen ist beispielsweise ein Datenbus oder eine sonstige Kommunikationsverbindung ausgebildet.

Ausgehend von diesem Basismodul lassen sich daher in einfacher Weise unterschiedliche Prüftisch-Konfigurationen ausbilden. Der Prüftisch ist in weiten Teilen frei für unterschiedliche Kabelbaum-Varianten konfigurierbar. Speziell wird unter frei konfigurierbar und damit unter unterschiedliche Prüftisch-Konfigurationen verstanden, dass die geometrische Form des Prüftisches konfigurierbar ist, dass sich diese also zwischen zwei Prüftisch-Konfigurationen unterscheidet.

Erfindungsgemäß sind hierzu zwei unterschiedliche Varianten möglich, die bevorzugt miteinander kombiniert sind. Zum einen lässt sich eine unterschiedliche Prüftisch-Konfiguration dadurch ausbilden, dass unterschiedliche Typen von Prüfaufsätzen zur Verfügung gestellt werden, die wahlweise auf das Basisgestell aufgesetzt werden können. Die Prüfaufsätze unterscheiden sich dabei vorzugweise allgemein im Hinblick auf ihre Form und speziell im Hinblick auf die insbesondere dreidimensionale Form und/oder Ausrichtung des Prüffeldes und damit einer durch dieses gebildeten Auflagefläche für den Kabelbaum. Dies ist insbesondere von besonderer Bedeutung, wenn verschiedene Kabelbaum-Typen eine unterschiedliche dreidimensionale Gestaltung aufweisen.

Zum anderen lässt sich eine unterschiedliche Prüftisch-Konfiguration dadurch ausbilden, dass seitlich am Basisgestell zumindest ein und vorzugweise mehrere Erweiterungsgestelle montiert werden, wobei jedes dieser Erweiterungsgestelle selbst wiederum einen Prüfaufsatz aufweist. Bei dieser Maßnahme erfolgt insbesondere eine Anpassung des Prüftisches an unterschiedlich große Kabelbäume.

Unter Prüftisch wird vorliegend jeweils die endkonfigurierte Ausgestaltung verstanden, bei der also das Basisgestell mit einem Prüfaufsatz versehen ist, oder bei dem ein oder mehrere Erweiterungsgestelle mit jeweils darauf angebrachten Prüfaufsätzen am Basisgestell (mit darauf aufgesetztem Prüfaufsatz) angebracht sind. Das Tischgestell ist je nach Konfiguration durch das Basisgestell oder durch das Basisgestell in Kombination mit ein oder mehreren Erweiterungsgestellen gebildet.

Ein jeweiliger Prüfaufsatz weist jeweils ein Aufsatz-spezifisches Prüffeld auf. Ist am Basisgestell zumindest ein oder sind mehrere Erweiterungsgestelle angebracht, so bilden die mehreren Aufsatz-spezifischen Prüffelder das (Gesamt-) Prüffeld des Prüftisches aus. Dieses Prüffeld des Prüftisches definiert zugleich eine Auflagefläche, auf die der jeweilige Kabelbaum aufgelegt wird. Ein jeweiliges Prüffeld weist die mehreren Prüfmodule auf, häufig ergänzt um Leermodule, bei denen es sich beispielsweise um Blindmodule oder um einfache Abdeckungen handelt. Alternativ ist ein Leermodul durch einen Freiraum gebildet. Insbesondere ist das jeweilige Prüffeld ausschließlich durch solche Module (Prüfmodule ggf. ergänzt um Leermodule) gebildet. Diese definieren daher die gesamte Auflagefläche.

Bei den Kabelbaum-Elementen handelt es sich beispielsweise um die in der Beschreibungseinleitung erwähnten Stecker, die an jeweils einem Strang des Kabelbaums endseitig angeschlossen, und / oder um elektronische oder elektrische Baueinheiten, beispielsweise Steuermodule, Aktoren und / oder Sensoren, die Teil des Kabelbaums sind.

Der zu prüfende Kabelbaum weist jeweils typischerweise eine verzweigte Struktur mit einem Hauptstrang und mehreren von diesem abzweigenden Teilsträngen auf.

In bevorzugter Ausgestaltung unterscheiden sich die unterschiedlichen Typen der Prüfaufsätze im Hinblick auf die Orientierung einer durch das jeweilige Prüffeld gebildeten Auflagefläche und/oder im Hinblick auf ihre Form. Ein jeweiliger Prüfaufsatz ist typischerweise gebildet durch ein Prüfgestell, auf dem die Module, nämlich die Prüfmodule und gegebenenfalls Leermodule angeordnet sind. Über das Prüfgestell ist typischerweise die Form und/oder die Orientierung der Auflagefläche vorgegeben.

In zweckdienlicher Ausgestaltung sind zumindest zwei oder zumindest drei und beispielsweise genau drei unterschiedlich ausgebildete Prüfaufsätze mit unterschiedlich orientierten Auflageflächen bereitgestellt. Unter unterschiedlich orientiert wird verstanden, dass die Auflageflächen der verschiedenen Prüfaufsätze insbesondere nicht parallel zueinander verlaufen und beispielsweise relativ zu einer horizontalen Ebene unterschiedlich orientiert sind oder zumindest unterschiedlich orientierte Teilbereiche aufweisen.

Die Auflageflächen sind vorzugsweise ausgewählt aus einer horizontalen Auflagefläche, einer insbesondere unter einem spitzen Winkel gegenüber der Horizontalen geneigten Auflagefläche sowie einer abgewinkelten Auflagefläche. Die abgewinkelte Auflagefläche weist daher zumindest oder genau zwei unter einem Winkel zueinander orientierte Teilflächen auf. Speziell ist die abgewinkelte Auflagefläche durch eine sogenannte Piano-Form ausgebildet, bei der eine erste, vordere Teilfläche horizontal oder geneigt verläuft und hieran sich eine zweite, hierzu abgewinkelte hintere Teilfläche anschließt. Diese ist unter einen deutlich größeren Winkel (z.B. unter zumindest einen um 20° oder 30° größeren Winkel) bezüglich der Horizontalen orientiert als die erste Teilfläche und verläuft beispielsweise im Wesentlichen vertikal und ist beispielsweise unter einem Winkel zwischen 60° und 80° bezüglich der Horizontalen orientiert.

Derartige unterschiedlich orientierte Auflageflächen werden für unterschiedliche Prüfszenarien eingesetzt. Hierbei handelt es sich um deutlich verschiedene Prüftisch-Konfigurationen. Für diese mussten bisher unterschiedlich angefertigte Prüftische eingesetzt werden. Durch den hier beschriebenen modularen Aufbau mit dem Basismodul (Basisgestell zuzüglich zentraler Prüfeinheit) und mit den unterschiedlichen Typen an Prüfaufsätzen lassen sich demgegenüber die unterschiedlichen Prüftisch-Formen mit geringem Aufwand konfigurieren.

In zweckdienlicher Ausgestaltung weist das Prüftisch-System mehrere Erweiterungsgestelle auf, wobei diese in unterschiedlichen Varianten an das Basisgestell montierbar sind, und zwar derart, dass unterschiedliche Gestell-Konfigurationen bestehend aus dem Basisgestell und den Erweiterungsgestellen ausgebildet werden können. Damit können insbesondere unterschiedliche Kabelbaum-Geometrien oder Kabelbaum-Größen nachgebildet werden.

In bevorzugter Ausgestaltung lassen sich als unterschiedliche Gestell-Konfigurationen eine lineare Konfiguration sowie eine abgewinkelte Konfiguration ausbilden. Bei der linearen Konfiguration schließen sich die einzelnen Gestelle (Basisgestell sowie Erweiterungsgestelle) in einer (Längs-) Richtung aneinander an. Bei einer abgewinkelten Konfiguration erstreckt sich das eine Gestell in einer Längsrichtung und das andere Gestell ist schräg und insbesondere senkrecht hierzu orientiert. Grundsätzlich lassen sich bei der abgewinkelten Konfiguration eine Vielzahl von unterschiedlichen Konfigurationen ausbilden. Speziell lässt sich eine L-Konfiguration oder auch eine H-Konfiguration ausbilden.

In bevorzugter Ausgestaltung ist zwischen zwei Gestellen, nämlich zwischen Basisgestell und einem Erweiterungsgestell oder auch zwischen zwei benachbarten Erweiterungsgestellen jeweils ein Verbindungsgestell angebracht. Bei diesem Verbindungsgestell handelt es sich insofern um eine Adapterteil, mit dessen Hilfe sich die zwei Gestelle verbinden lassen. Die Gestelle weisen üblicherweise Profile auf, beispielsweise Metallprofile, wobei diese über das Verbindungsgestell miteinander verbunden werden. Speziell werden beispielsweise zwei Längsprofile über das Verbindungsgestell miteinander verbunden. Hierzu wird beispielsweise ein jeweiliges Längsprofil in eine Aufnahme des Verbindungsgestells eingesteckt und mit diesem verbunden, beispielsweise verschraubt oder mit einem Befestigungsflansch des Verbindungsgestells verbunden, insbesondere verschraubt. Durch das Verbindunggestell ist daher insbesondere eine einfache Verbindung zwischen zwei benachbarten Gestellen erreicht.

Das Verbindungsgestell und die zwei Gestelle, die über das Verbindungsgestell miteinander verbunden sind, schließen sich in Längsrichtung aneinander an. Das Verbindungsgestell weist eine deutlich geringere Ausdehnung (Breite) in Längsrichtung auf als das Basisgestell und / oder das Erweiterungsgestell. Die Ausdehnung ist beispielsweise um zumindest den Faktor 5 oder auch den Faktor 10 geringer als die entsprechende Ausdehnung (in Längsrichtung) des Basisgestells und / oder des Erweiterungsgestells.

In zweckdienlicher Ausgestaltung sind am Verbindungsgestell ebenfalls Prüfmodule und ggf. ergänzend oder auch alternativ Leermodule angebracht. Diese Module bilden daher insgesamt einen Teil der Auflagefläche und damit des Prüffeldes aus, auf dem der Kabelbaum während der Prüfung aufliegt. Die Anzahl der in Längsrichtung nebeneinander angeordneten Module ist wiederum geringer (zumindest um den Faktor 5 oder zumindest um den Faktor 10) als die Anzahl der nebeneinander angeordneten Prüfmodule bei dem Basisgestell und / oder bei dem Erweiterungsgestell. Bevorzugt ist maximal eine Reihe oder es sind maximal zwei Reihen oder maximal 3 Reihen an Prüfmodulen am Verbindungsgestell angebracht. Es sind also am Verbindungsgestell in Längsrichtung maximal 1, 2 oder 3 Prüfmodule / Leermodule nebeneinander angebracht.

Speziell weist das Verbindungsgestell eine gleiche Querschnittsgeometrie wie die anderen Gestelle, nämlich wie das Basisgestell und die Erweiterungsgestelle auf. Speziell weist das Verbindungsgestell ein Bodenteil, insbesondere ein Bodenprofil oder eine Bodenstrebe sowie zwei Seitenteile, insbesondere Seitenprofile oder Seitenstreben auf. Diese Teile sind vorzugsweise identisch orientiert wie entsprechende Teile der benachbarten und über das Verbindungsgestell miteinander verbundenen Gestelle.

Bevorzugt ist das Prüffeld von Randleisten umgeben, die also quasi das Prüffeld begrenzen. Bei einer Basiskonfiguration mit lediglich einem Basisgestell mit darauf angebrachtem Prüfaufsatz ist dieses Prüffeld umfangsseitig von derartigen Randleisten begrenzt. Bei einer Konfiguration mit zumindest zwei aneinander anschließenden Gestellen wird - ausgehend von einer solchen Basiskonfiguration - auf eine der Randleisten quasi verzichtet, d. h. diese wird im Vergleich zur Basiskonfiguration entfernt. In gleicher Weise ist auch das angeschlossene Erweiterungsgestell grundsätzlich zur Aufnahme von umfangsseitig angeordneten Randleisten vorgesehen. Auch beim Erweiterungsgestell ist bevorzugt auf eine solche Randleiste im Verbindungsbereich zum benachbarten Gestell verzichtet. Durch den Verzicht auf diese Randleisten wird ein Freiraum geschaffen, in dem Prüfmodule und / oder Leermodule angeordnet sind, wobei der Freiraum vorzugsweise vollständig von diesen Modulen überdeckt und verschlossen ist. Die dem Verbindungsgestell zugeordneten Prüfmodule/Leermodule füllen daher einen Flächenabschnitt zwischen den Prüfmodulen/Leermodulen der beiden benachbarten Gestelle aus, sodass insgesamt ein durchgehendes, einheitliches Prüffeld des ausgebildeten Prüftisches erreicht ist.

Ein jeweiliges Prüffeld ist in bevorzugter Ausgestaltung durch matrixförmig angeordnete Module ausgebildet, wobei die Module ausgewählt sind aus den Prüfmodulen und den bereits erwähnten Leermodulen. Bei Letzteren handelt es sich beispielsweise um Dummy-Module, also um Einsätze mit einer gleichen Querschnittsgeometrie wie die Prüfmodule, oder um eine einfache Abdeckung. In einer einfachsten Ausführungsvariante handelt es sich bei den Leermodulen um unbesetzte Plätze. Üblicherweise weisen die Leermodule jedoch zumindest ein Flächenelement auf, so dass durch die Prüfmodule und die Leermodule ein zusammenhängendes Prüffeld und damit eine zusammenhängende, durchgehende Auflagefläche ausgebildet ist.

Die einzelnen Module sind bevorzugt jeweils von Tragstreben gehalten, die entweder matrixförmig angeordnet sind oder sich lediglich in eine Richtung erstrecken, wobei zwischen zwei benachbarten Tragstreben allgemein ein Hohlraum ausgebildet ist, in den ein jeweiliges Modul eingesetzt werden kann. Die einzelnen Module weisen üblicherweise eine rechteckförmige und beispielsweise eine quadratische Grundfläche auf.

Über das Basisgestell werden in zweckdienlicher Ausgestaltung sämtliche Versorgungseinheiten für sämtliche Prüfmodule bereitgestellt, unabhängig von der konkret gewählten Prüftisch-Konfiguration. Innerhalb des Basisgestells sind daher sämtliche erforderliche Einheiten angeordnet, beispielsweise ein oder mehrere und insbesondere alle der nachfolgenden Einheiten, nämlich einer Einheit zur elektrischen Energieversorgung, einer Einheit zur Versorgung mit Fluiden, insbesondere zur Versorgung mit Druckluft, sowie weiterhin elektrische/elektronische Steuereinheiten, Auswerteeinheiten, wie beispielsweise ein erforderlicher Rechner, ein Stromversorgungsteil (Netzteil) usw. Die Erweiterungsgestelle sind umgekehrt vorzugsweise frei von solchen Versorgungseinheiten.

Die Erweiterungsgestelle werden daher lediglich über Versorgungsleitungen mit diesen Versorgungseinheiten sowie mit der zentralen Prüfeinheit im Basisgestell verbunden, um somit die erforderliche Versorgung bzw. den Anschluss der Prüfmodule des jeweiligen Erweiterungsgestells zu gewährleisten.

Zweckdienlicherweise weist jedes Erweiterungsgestell ein oder mehrere Teil-Versorgungsleitungen auf, die über geeignete Schnittstellen, beispielsweise Steckverbinder, mit weiteren Teil-Versorgungsleitungen des benachbarten Gestells verbunden werden können und im aufgebauten Zustand verbunden sind. Hierdurch ist daher ein einfacher, montagefreundlicher Anschluss eines Erweiterungsgestells ermöglicht.

In zweckdienlicher Ausbildung sind die Erweiterungsgestelle zueinander identisch ausgebildet. Hierdurch wird also ein Gleichteile-System verwirklicht, wodurch die Kosten gering gehalten sind.

Bevorzugt weist ein jeweiliges Erweiterungsgestell eine gleiche Länge und Breite wie das Basisgestell auf. Das Erweiterungsgestell und das Basisgestell weisen daher eine gleiche Oberseite auf, auf die das jeweilige Prüfmodul aufsetzbar ist. In gleicher Weise weisen auch die unterschiedlichen Prüfaufsätze bevorzugt die gleiche Länge und Breite auf, so dass sie eine gleiche Unterseite aufweisen, mit der Sie auf das jeweilige Gestell aufgesetzt werden können. Dadurch lässt sich jeder Prüfaufsatz auf jedem Gestell anordnen.

Bei einer Prüftisch-Konfiguration, bei der der Prüftisch zumindest ein Erweiterungsgestell ergänzend zum Basisgestell aufweist, sind auf dem Basisgestell und allen daran angeschlossenen Erweiterungsgestellen vorzugsweise ein gleicher Typ Prüfaufsatz aufgesetzt. Hierdurch wird insgesamt ein einheitliches Prüffeld und auch eine einheitliche Auflagefläche mit identischer Orientierung über sämtliche Prüfaufsätze bereitgestellt.

In zweckdienlicher Weiterbildung ist das Tischgestell weiterhin von einer Installationstraverse überspannt, welche modular ausgebildet ist und sich beispielsweise aus einzelnen Modulelementen zusammensetzt. Die Installationstraverse weist typischerweise zwei randseitige, vertikale Streben auf, die an gegenüberliegenden Enden des Prüftisches und insbesondere an einem jeweiligen Gestell an einer Seitenwand angebracht sind. Die Installationstraverse weist weiterhin einen von den vertikalen Streben getragenen horizontaler Abschnitt auf. Dieser setzt sich aus den mehreren Modulelementen zusammen, sofern mehrere Gestelle aneinandergereiht sind. Ein jeweiliges Modulelement ist insbesondere als eine Profilelement oder eine Strebe oder sonstiges Trägerelement ausgebildet. Die Länge eines jeweiligen Modulelements entspricht vorzugsweise der Länge des zugeordneten Gestells. Die Modulelemente lassen sich beispielsweise über eine Steckverbindung miteinander verbinden. Über die Installationstraverse wird beispielsweise eine Beleuchtung für das Prüffeld bereitgestellt und einzelnen Modulelemente sind beispielsweise als einzelne Leuchtelemente ausgebildet. Daneben oder alternativ können über die Installationstraverse auch andere Elemente, wie beispielsweise Bearbeitungswerkzeuge und / oder Versorgungsanschlüsse (elektrischer Anschluss, Fluidanschluss, Kommunikationsschnittstelle) bereitgestellt werden.

Ein Ausführungsbeispiel der Erfindung wird nachfolgend anhand der Figuren näher erläutert. Diese zeigen in vereinfachten Darstellungen:
- FIG 1: einen Prüftisch mit einem horizontal orientierten Prüffeld eines Prüftisch-Systems in einer Basis-Konfiguration,
- FIG 2: einen Prüftisch mit einem Basisgestell als Tischgestell und einem darauf angebrachten Prüfaufsatz in einer Piano-Form,
- FIG 3: den in FIG 1 dargestellten Prüftisch ohne Prüfaufsatz,
- FIG 4: eine perspektivische Darstellung eines Prüfaufsatzes in Piano-Form,
- FIG 5: eine perspektivische Darstellung eines Prüfaufsatzes mit schräg geneigtem Prüffeld,
- FIG 6: eine perspektivische Ansicht auf ein Basismodul mit einem Basisgestell, einer darin angeordneten zentralen Prüfeinheit sowie mit einem darauf angebrachten Prüfaufsatz,
- FIG 7: einen Prüftisch in einer linearen Konfiguration mit einem Basismodul und zwei daran angeschlossenen Erweiterungs-Modulen, sowie
- FIG 8: eine perspektivische Darstellung eines Verbindungsgestells mit daran angebrachten Prüfmodulen/Leermodulen.

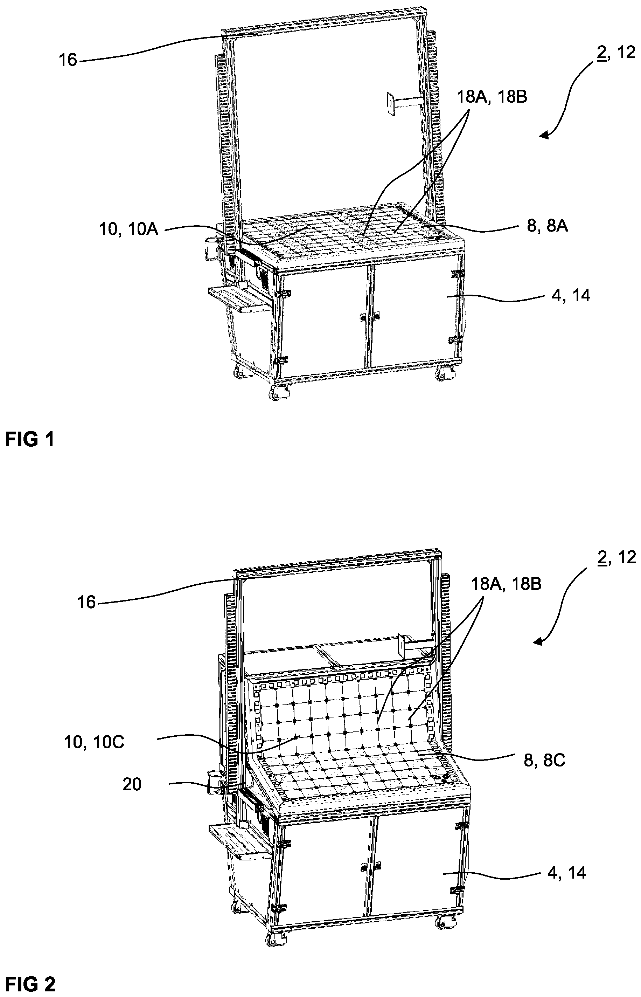

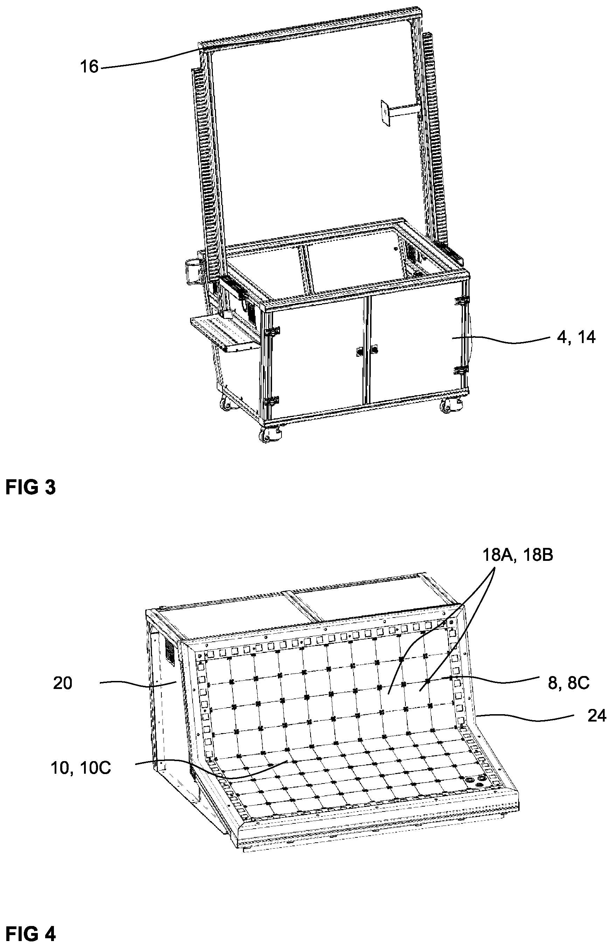

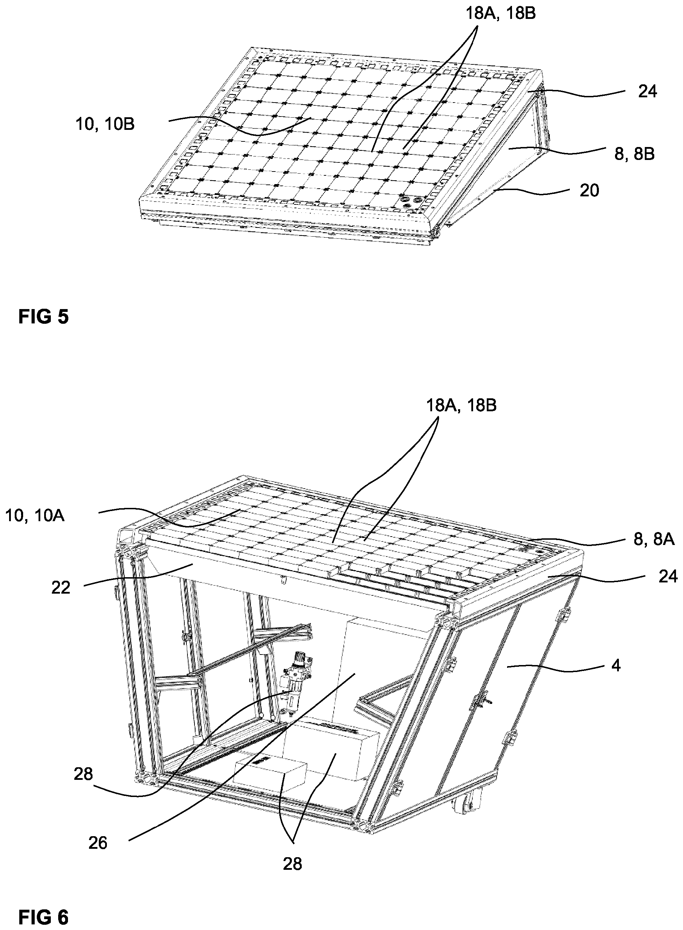

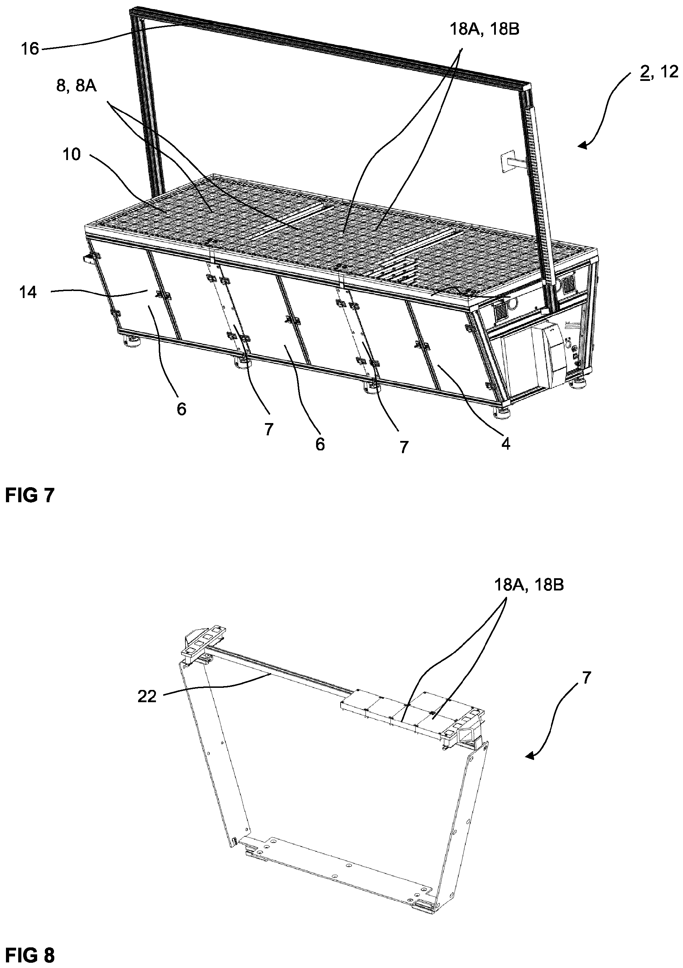

Das zu den Figuren 1-8 nachfolgend im Detail beschriebene Prüftisch-System 2 dient zur Überprüfung der Funktionsfähigkeit eines hier nicht näher dargestellten Kabelbaums, welcher insbesondere als ein Kabelbaum für ein Fahrzeug, insbesondere ein Kraftfahrzeug ausgebildet ist. Das Prüftisch-System 2 ist modular aufgebaut und weist als wesentliche Modulteile ein Basisgestell 4 (vergleiche hierzu insbesondere Figuren 3, 6), mehrere Erweiterungsgestelle 6 (vergleiche hierzu insbesondere FIG 7), Verbindungsgestelle 7 (vergleiche hierzu insbesondere FIG 8) sowie mehrere unterschiedlich ausgebildete Prüfaufsätze 8 auf, nämlich einen horizontalen Prüfaufsatz 8A mit einem horizontal orientierten Aufsatz-spezifischen Prüffeld 10A, einen schräg orientierten Prüfaufsatz 8B mit einem schräg geneigten Aufsatz-spezifischen Prüffeld 10B sowie einen Prüfaufsatz 8C in Piano-Form, mit einem Aufsatz-spezifischen Prüffeld 10C, welches durch zwei winklig zueinander orientierte Teilflächen gebildet ist (vergleiche hierzu insbesondere Figuren 1 sowie 4 und 5).

Unterschiedlich ausgebildete Prüftisch-Konfigurationen sind beispielhalft in den Figuren 1, 2 sowie 7 dargestellt. Eine jede dieser Prüftisch-Konfigurationen zeigt dabei einen (Gesamt-) Prüftisch 12, welcher jeweils zusammengesetzt ist aus mehreren der zuvor genannten Modulteile. Ein jeder dieser Prüftische 12 weist ein Tischgestell 14 sowie ein Prüffeld 10 auf, welches je nach Konfiguration durch eines der Aufsatz-spezifischen Prüffelder 10A - 10C gebildet ist, oder sich aus mehreren dieser Aufsatz-spezifischen Prüffelder 10A - 10C zusammensetzt. Das Prüffeld 10 bildet zugleich eine Auflagefläche, auf die der Kabelbaum während der Durchführung des Prüfprozesses aufliegt.

Analog setzt sich das Tischgestell 14 aus dem Basisgestell 4 sowie - je nach Prüftisch-Konfiguration - ein oder mehreren der Erweiterungsgestellen 6 zusammen. Ein jeweiliges Erweiterungsgestell 6 kann mit dem Basisgestell 4 oder auch mit einem anderen Erweiterungsgestell 6 verbunden werden.

Weiterhin ist optional eine modular aufgebaute Installationstraverse 16 vorgesehen, welche den Prüftisch 12 überspannt. Diese weist zwei seitliche Streben sowie eine von diesen getragene Quertraverse auf. Diese setzt sich - bei mehreren nebeneinander angeordneten Gestellen 4, 6 - aus mehreren einzelnen Modulelementen zusammen. Diese sind insbesondere als Beleuchtungselemente ausgebildet, mit denen das Prüffeld 10 ausgeleuchtet werden kann.

Die Gestelle, also das Basisgestell 4 sowie die Erweiterungsgestelle 6 weisen vorzugsweise die gleiche Größe und Form auf. Speziell weisen Sie die gleiche Länge und Breite auf. In gleicher Weise weisen auch die Prüfaufsätze 8 jeweils insgesamt die gleiche Länge und Breite auf. Dadurch lässt sich jeder Prüfaufsatz 8 auf jedem Gestell 4, 6 anordnen.

Ein jeweiliges Gestell 4, 6 ist im Ausführungsbeispiel gebildet durch mehrere miteinander verbundene Streben, die insbesondere als Profileelemente ausgebildet sind. In einer Seitenansicht oder auch in einen Querschnitt betrachtet, weisen die Gestelle 4, 6 im Ausführungsbeispiel eine trapezförmige Ausgestaltung auf.

Allgemein weisen die Gestelle 4, 6 ein Bodenteil, eine Vorderwand sowie eine Rückwand und zwei in einer Längsrichtung gegenüberliegende Seitenteile auf. Die jeweilige Vorderwand sowie Rückwand sind jeweils mit ein oder mehreren Wandteilen verschlossen. An der Rückwand und Vorderwand sind die Wandteile vorzugsweise als Türen ausgebildet. Grundsätzlich können alle Wände als Türen ausgebildet sein oder mit Türen versehen sein.

Bei einem Prüftisch 12 sind die beiden in Längsrichtung gegenüberliegenden Seitenteile vorzugsweise ebenfalls durch Wandteile verschlossen. Diese Wandteile sind demgegenüber in einem Verbindungsbereich zwischen benachbarten Gestellen 4,6 weggelassen. Insgesamt ist daher bei einer jeweiligen Prüftisch-Konfiguration ein durchgehend offener Innenraum innerhalb der verbundenen Gestelle 4, 6 gebildet.

Unterschiedliche Prüftisch-Konfigurationen lassen sich zum einen dadurch ausbilden, dass auf dem Basisgestell 4 unterschiedliche Typen der Prüfaufsätze 8 aufgesetzt werden, wie dies beispielhaft anhand FIG 1 sowie FIG 2 dargestellt ist.

Ein jeweiliger Prüfaufsatz 8 weist typischerweise ein Aufsatzgestell 20 auf, welches Module trägt. Bei den Modulen handelt es sich um Prüfmodule 18A und ergänzend vorzugsweise auch um Leermodule 18B.

Das Aufsatzgestell 20 weist hierzu insbesondere unter anderem auch Tragstreben 22 auf (vergleiche hierzu insbesondere FIG 6), die sich im Ausführungsbeispiel ausschließlich in Querrichtung erstrecken. Mehrere dieser Tragstreben 22 sind in Längsrichtung unter einem Rastermaß nebeneinander angeordnet. Zwischen sich weisen diese daher jeweils einen Freiraum auf, in die die Module 18A, 18B eintauchen. Die einzelnen Module 18A, 18B werden daher von zwei gegenüberliegenden Tragstreben 20 getragen und sind mit diesen beispielsweise verschraubt.

Ein jeweiliges Aufsatzgestell 20 gibt dabei insbesondere auch die geometrische Orientierung des Prüffeldes 10 und damit der Auflagefläche für den Kabelbaum vor. Das Aufsatzgestell 20 ist daher bei dem Prüfaufsatz 18C selbst in Pianoform ausgebildet und bei dem schräg geneigten Prüfaufsatz 8B schräg geneigt ausgebildet.

Die einzelnen Prüfaufsätze 8 sind zweckdienlicherweise als Montageeinheiten ausgebildet, wie sie beispielsweise in FIG 4 oder in FIG 5 dargestellt sind. Diese Montageeinheiten können insgesamt mit dem Aufsatzgestell 20 auf dem Basisgestell 4 (vergleiche hierzu insbesondere FIG 3) als eine gemeinsame Baueinheit aufgesetzt werden. Dies erleichtert die Montage.

Ein jeweiliges Prüffeld 10 ist bei einer jeweiligen Prüftisch-Konfiguration vorzugsweise von Randleisten 24 umgeben. Diese Randleisten 24 umgeben dabei vorzugsweise jeweils ein jeweiliges Aufsatz-spezifisches Prüffeld 10A - 10C.

Bei einer Prüftisch-Konfiguration, wie sie beispielsweise in Figur 7 dargestellt ist, und bei der neben dem Basisgestell 4 ein oder mehrere Erweiterungsgestelle 6 am Basisgestell 4 angeschlossen sind, ist zwischen zwei benachbarten Gestellen 4,6 jeweils das Verbindungsgestell 7 angebracht, wie es in Figur 8 dargestellt ist.

Dieses weist die gleiche Querschnittsform wie die anderen Gestelle 4,6 auf, weist also im Ausführungsbeispiel ebenfalls eine trapezförmige Querschnittsform auf. Es weist eine Bodenstrebe sowie zwei an dieser angebrachte Seitenstreben auf. Die Seitenstreben weisen in Längsrichtung eine Breite beispielsweise von einigen Zentimetern (5-20 cm) auf und sind insbesondere als Blenden ausgebildet, die den Verbindungsbereich zwischen den benachbarten Gestellen 4,6 überdecken. Die Verbindungsgestelle 7 dienen zur Verbindung der benachbarten Gestelle 4,6. Hierzu werden mittels des Verbindungsgestells 7 insbesondere Längsstreben dieser Gestelle 4,6 miteinander verbunden. Diese werden beispielsweise jeweils am Verbindungsgestell 7 angeschraubt und somit über dieses miteinander verbunden.

Hervorzuheben ist, dass das Verbindungsgestell 7 zumindest im montierten Endzustand ebenfalls Module trägt, nämlich wahlweise Prüfmodule 18A und/oder Leermodule18B, wie dies beispielhaft in der FIG 8 dargestellt ist (In FIG 8 sind nur einige Module 18A, 18B dargestellt). Diese Module 18A, 18B bilden daher ebenfalls einen Teil des Prüffeldes 10 des ausgebildeten Prüftisches 10 aus. Die beiden Seitenstreben sind hierzu insbesondere über eine Tragstrebe 22 miteinander verbunden. Zwischen dieser und jeweils der randseitig äußersten Tagstrebe 22 des sich anschließenden, benachbarten Prüfaufsatzes 8 ist daher ein freier Aufnahmeraum ausgebildet, in den die Module 18 A, 18 B eintauchen können.

Diese Tragstrebe 22 bildet ebenfalls ein Aufsatzgestell für das Verbindungsgestell 7 aus oder ist zumindest ein Teil eines solchen Aufsatzgestells. Zu dem modularen Prüftisch-System 2 zählen daher auch unterschiedlich ausgebildete Aufsatzgestelle für das Verbindungsgestell 7, wobei diese analog zu den bisher beschriebenen Aufsatzgestellen 20 ebenfalls die Form vorgeben, also eine horizontale, eine schräg geneigte oder eine Piano-Form. Allgemein weist das Verbindungsgestell 7 und auch die zugehörigen Aufsatzgestelle eine deutlich kürzere Länge (zumindest Faktor 10) auf, als die Gestelle 4, 6 und deren Prüfaufsätze 8 / Aufsatzgestelle 20.

Die Breite des Verbindungsgestells 7 in Längsrichtung ist in bevorzugter Ausgestaltung insgesamt derart gewählt, dass lediglich eine (einzige) Tragstrebe 22 angeordnet ist, sodass beidseitig zu dieser jeweils genau eine Reihe an Modulen 18A, 18 B eingesetzt werden kann. Anders ausgedrückt trägt das Verbindungsgestell 7 genau zwei in Längsrichtung nebeneinander angeordnete Reihen von Modulen 18A, 18B.

Ein wesentlicher Aspekt des modularen Prüftisch-Systems 2 ist weiterhin darin zu sehen, dass über das Basisgestell 4 die zentrale Versorgung des gesamten Prüftisches 10, unabhängig von der jeweiligen spezifischen Prüftisch-Konfiguration bereitgestellt ist. Wie insbesondere anhand FIG 6 zu erkennen ist, ist am Basisgestell 4, insbesondere in dessen Innenraum zumindest eine zentrale Prüfeinheit 26 angeordnet, die mit sämtlichen Prüfmodulen 18A des gesamten Prüftisches 12 (also Unabhängigkeit von der speziellen Prüftisch-Konfiguration) und beispielsweise über geeignete, hier nicht näher dargestellte Verbindungsleitungen oder gegebenenfalls auch drahtlos verbunden ist. Hierbei werden die einzelnen Prüfmodule 18A beispielsweise mit Energie versorgt, alternativ werden sie über Signalleitungen angeschlossen, über die beispielsweise ein Prüfsignal bereitgestellt wird bzw. ein Prüf- oder Messsignal wieder an die Prüfeinheit 26 zurück übermittelt und ausgewertet wird. Ergänzend oder alternativ sind die Prüfmodule 18A über eine Kommunikationsverbindung mit der zentralen Prüfeinheit 26 verbunden. Dies ist insbesondere der Fall, falls es sich bei den Prüfmodule 18A um intelligente Prüfmodule handelt, die beispielsweise selbst zur Erzeugung von Prüfsignalen und/oder zur Auswertung der angelegten Prüfsignale ausgebildet sind.

In bevorzugter Ausgestaltung sind weitere Versorgungseinheiten 28 und insbesondere sämtliche Versorgungseinheiten 28 innerhalb des Basisgestell 4 angebracht, die zur Versorgung der Prüfmodule 18A erforderlich sind. Beispielsweise handelt es sich hierbei um eine Drucklufteinheit, ein Netzteil für die Energieversorgung, eine Recheneinheit, beispielsweise ein Computer, wobei dieser auch Teil der Prüfeinheit 26 sein kann oder diese ausbildet usw. Diese Prüfeinheit 26 sowie gegebenenfalls die weitere Versorgungseinheiten 28 bilden daher zentrale Einheiten, die lediglich einmal angeordnet sind und für sämtliche Prüftisch-Konfigurationen zur Versorgung der verschiedenen Prüfmodule 18A dienen. Lediglich das Basisgestell 4 weist diese Einheiten auf, wohingegen die Erweiterungsgestelle 6 keinerlei solche Einheiten aufweisen und daher bevorzugt frei von jeglichen Versorgungseinheiten oder Prüfeinheiten sind.

Insgesamt lässt sich hierdurch ein modulares Prüftisch-System 2 bereitstellen, welches in unterschiedlichsten Prüftisch-Konfigurationen aufgebaut werden kann, sodass es für unterschiedlichste Kabelbaum-Varianten und deren Prüfung konfiguriert werden kann. Durch den modularen Aufbau mit den verschiedenen hier beschriebenen Einheiten ist dabei jeweils ohne großen Aufwand eine Umrüstung des Prüftisches 12 in einfacher Weise ermöglicht. Insbesondere wird hierdurch erreicht, dass die einzelnen Module für die unterschiedlichsten Kabelbaum-Varianten herangezogen werden können.

Die eigentliche Prüfung der Kabelbäume erfolgt in an sich bekannter Weise.

### Bezugszeichenliste

- 2: Prüftisch-System
- 4: Basisgestell
- 6: Erweiterungsgestell
- 7: Verbindungsgestell
- 8: Prüfaufsatz
- 8A: horizontaler Prüfaufsatz
- 8B: schräg geneigt der Prüfaufsatz
- 8C: Prüfaufsatz in Piano-Form
- 10: Prüffeld
- 10A: Aufsatz-spezifisches horizontales Prüffeld
- 10B: Aufsatz-spezifisches schräg geneigtes Prüffeld
- 10C: Aufsatz-spezifisches Prüffeld in Piano-Form
- 12: Prüftisch
- 14: Tischgestell
- 16: Installationstraverse
- 18A: Prüfmodul
- 18B: Leermodul
- 20: Aufsatzgestell
- 22: Tragstrebe
- 24: Randleiste
- 26: zentrale Prüfeinheit
- 28: weitere Versorgungseinheiten

## Patentansprüche

1. Prüftisch-System (2) zur Prüfung von Kabelbäumen mit einem Tischgestell (14), mit zumindest einem darauf angebrachten Prüfaufsatz (8), welcher ein Prüffeld (10) mit mehreren Prüfmodulen (18A) zum Anschluss von Kabelbaum-Elementen aufweist, sowie mit einer zentralen Prüfeinheit (26), welche mit den Prüfmodulen (18A) verbunden ist, wobei das Prüftisch-System (2) modular aufgebaut ist und in unterschiedlichen Prüftisch-Konfigurationen aufbaubar ist und hierzu ein Basisgestell (4) aufweist, welches die zentrale Prüfeinheit (26) aufweist, wobei das Prüftisch-System (2) weiterhin
- mehrere unterschiedliche Typen von Prüfaufsätzen (8) aufweist, die zur Ausbildung der unterschiedlichen Prüftisch-Konfigurationen wahlweise auf das Basisgestell (4) aufgesetzt werden können und deren Prüfmodule (18A) jeweils mit der zentralen Prüfeinheit (26) im montierten Zustand verbunden sind, und / oder
- zumindest ein Erweiterungsgestell (6) aufweist, welches seitlich am Basisgestell (4) zur Ausbildung der unterschiedlichen Prüftisch-Konfigurationen montierbar ist, wobei auf dem zumindest einen Erweiterungsgestell (6) im montierten Zustand ein Prüfaufsatz (8) angebracht ist, dessen Prüfmodule (18A) im montierten Zustand mit der zentralen Prüfeinheit (26) verbunden sind.

2. Prüftisch-System (2) nach dem vorhergehenden Anspruch, bei dem die unterschiedlichen Typen der Prüfaufsätze (8) sich im Hinblick auf die Orientierung einer durch das jeweilige Prüffeld (10) gebildeten Auflagefläche und / oder im Hinblick auf ihre Form unterscheiden.

3. Prüftisch-System (2) nach dem vorhergehenden Anspruch, welches zumindest zwei oder drei unterschiedlich ausgebildete Prüfaufsätze (8) mit unterschiedlich orientierten Auflageflächen umfasst, wobei die Auflageflächen vorzugsweise ausgewählt sind aus einer horizontalen Auflagefläche, einer geneigten Auflagefläche sowie einer abgewinkelten Auflagefläche.

4. Prüftisch-System (2) nach einem der vorhergehenden Ansprüche, welches mehrere Erweiterungsgestelle (6) aufweist und diese in unterschiedlichen Varianten an dem Basisgestell (4) montierbar sind, derart, dass unterschiedliche Gestell-Konfigurationen ausgebildet werden können.

5. Prüftisch-System (2) nach dem vorhergehenden Anspruch, wobei als Gestell-Konfiguration eine lineare Konfiguration oder eine abgewinkelte Konfiguration ermöglicht ist, wobei als abgewinkelte Konfigurationen insbesondere ein L-Konfiguration und / oder eine H-Konfiguration ermöglicht sind.

6. Prüftisch-System (2) nach einem der vorhergehenden Ansprüche, wobei zwischen zwei Gestellen, nämlich zwischen dem Basisgestell (4) und einem Erweiterungsgestell (6) und / oder zwischen zwei benachbarten Erweiterungsgestellen (6), jeweils ein Verbindungsgestell (7) angebracht ist.

7. Prüftisch-System (2) nach dem vorhergehenden Anspruch, wobei am Verbindungsgestell (7) ebenfalls Prüfmodule (18A) oder Leermodule (18B) angebracht sind.

8. Prüftisch-System (2) nach dem vorhergehenden Anspruch, wobei das Prüffeld (10) von Randleisten (24) umgeben ist, wobei bei einer Konfiguration mit den zumindest zwei Gestellen (4,6) auf eine dem jeweiligen Gestell (4,6) zugeordnete Randleiste (24) verzichtet ist und in dem dadurch geschaffenen Freiraum Prüfmodule (18A) oder Leermodule (18B) angebracht sind.

9. Prüftisch-System (2) nach einem der vorhergehenden Ansprüche, wobei ein jeweiliges Prüffeld (10) durch matrixförmig angeordnete Prüfmodule (18A) und / oder Leermodule (18B) gebildet ist.

10. Prüftisch-System (2) nach einem der vorhergehenden Ansprüche, wobei über das Basisgestell (4) sämtliche Versorgungseinheiten (26, 28) für sämtliche Prüfmodule (18A) bereitgestellt sind, unabhängig von der gewählten Prüftisch-Konfiguration.

11. Prüftisch-System (2) nach einem der vorhergehenden Ansprüche, wobei die Erweiterungsgestelle (6) zueinander identisch ausgebildet sind.

12. Prüftisch-System (2) nach einem der vorhergehenden Ansprüche, bei dem ein jeweiliges Erweiterungsgestell (6) eine gleiche Länge und Breite wie das Basisgestell (4) aufweist.

13. Prüftisch-System (2) nach einem der vorhergehenden Ansprüche, wobei das Tischgestell (14) von einer Installationstraverse (16) überspannt ist, welche modular aufgebaut ist und insbesondere zur Beleuchtung des Prüffeldes (10) ausgebildet ist.
